# EUROPÄISCHE PATENTSCHRIFT

(11) **EP 3 446 329 B1**
(45) Veröffentlichungstag und Bekanntmachung des Hinweises auf die Patenterteilung: **30.08.2023**
(21) Anmeldenummer: 17717389.5
(22) Anmeldetag: 11.04.2017
(51) Int. Cl.: H01L 21/02

(54) **SILIZIUMWAFER FÜR EIN ELEKTRONISCHES BAUELEMENT UND VERFAHREN ZU DESSEN HERSTELLUNG**
SILICON WAFER FOR AN ELECTRONIC COMPONENT AND METHOD FOR THE PRODUCTION THEREOF
PLAQUETTE DE SILICIUM POUR UN COMPOSANT ELECTRONIQUE, ET SON PROCÉDÉ DE PRODUCTION

(30) Priorität: 22.04.2016 DE 102016107557
(43) Veröffentlichungstag der Anmeldung: 27.02.2019
(73) Patentinhaber: Nexwafe GmbH, 79108 Freiburg (DE)
(72) Erfinder: REBER, Stefan, 79194 Gundelfingen (DE); SCHILLINGER, Kai, 79106 Freiburg (DE); SIEBKE, Frank, 79249 Merzhausen (DE)
(74) Vertreter: LBP Lemcke, Brommer & Partner Patentanwälte mbB
(86) Internationale Anmeldenummer: PCT/EP2017/058674
(87) Internationale Veröffentlichungsnummer: WO 2017/182329

(56) Entgegenhaltungen:
- CA-A- 721 884
- US-A1- 2013 075 855
- BRENDEL R: "REVIEW OF LAYER TRANSFER PROCESSES FOR CRYSTALLINE THIN-FILM SILICON SOLAR CELLS", JAPANESE JOURNAL OF APPLIED PHYSICS, JAPAN SOCIETY OF APPLIED PHYSICS, JP, Bd. 40, Nr. 7, PART 01, 1. Juli 2001 (2001-07-01), Seiten 4431-4439, XP001073140, ISSN: 0021-4922, DOI: 10.1143/JJAP.40.4431 in der Anmeldung erwähnt
- S Dubois ET AL: "Beneficial Effects of Dopant Compensation on Carrier Lifetime in Upgraded Metallurgical Silicon", The compiled state-of-the-art of PV solar technology and deployment : 23rd European Photovoltaic Solar Energy Conference, EU PVSEC ; proceedings of the international conference, held in Valencia, Spain, 1 - 5 September 2008, 1. Januar 2008 (2008-01-01), XP055388297, DE DOI: 10.4229/23rdEUPVSEC2008-2CV.4.36 ISBN: 978-3-936338-24-9 Gefunden im Internet: URL:http://http://apollonsolar.com/userfil es/file/Publi/Doping%202008%20PVSEC%20-%20 Beneficial%20Effects%20of%20Dopant%20Compe nsation%20on%20Carrier%20Lifetime%20in%20U pgraded%20Metallurgical%20Silicon.pdf [gefunden am 2017-06-30]
- GEORGY SAMSONIDZE ET AL: "Compensation-doped silicon for photovoltaic applications", PHYSICAL REVIEW. B, CONDENSED MATTER AND MATERIALS PHYSICS, Bd. 84, Nr. 19, 1. November 2011 (2011-11-01), XP055386662, US ISSN: 1098-0121, DOI: 10.1103/PhysRevB.84.195201
- ANDRÉS CUEVAS ET AL: "Compensation Engineering for Silicon Solar Cells", ENERGY PROCEDIA, Bd. 15, 1. Januar 2012 (2012-01-01), Seiten 67-77, XP055376432, NL ISSN: 1876-6102, DOI: 10.1016/j.egypro.2012.02.008
- SCHMICH ET AL: "Silicon CVD deposition for low cost applications in photovoltaics", SURFACE AND COATINGS TECHNOLOGY, ELSEVIER BV, AMSTERDAM, NL, Bd. 201, Nr. 22-23, 9. August 2007 (2007-08-09), Seiten 9325-9329, XP022191985, ISSN: 0257-8972, DOI: 10.1016/J.SURFCOAT.2007.04.089

## Beschreibung

Die Erfindung betrifft einen Siliziumwafer zur Herstellung eines elektronischen Bauelementes gemäß Oberbegriff des Anspruchs 7 sowie ein Verfahren zu dessen Herstellung gemäß Oberbegriff des Anspruchs 1.

Für großflächige elektronische Bauteile wie beispielsweise großflächige Leuchtelemente oder photovoltaische Solarzellen besteht ein Bedarf an kostengünstigen Halbleiterwafern mit hoher elektronischer Güte, da bei solchen Bauelementen die Materialkosten des Halbleiterwafers einen wesentlichen Anteil an den Kosten des Gesamtprodukts darstellen.

Aus S. Dubois et al. "BENEFICIAL EFFECTS OF DOPANT COMPENSATION ON CARRIER LIFETIME IN UPGRADED METALLURGICAL SILICON", 23rd European Photovoltaic Solar Energy Conference and Exhibition, 1-5 September 2008, Valencia, Spain, ist ein Verfahren zur Behandlung von Solar Grade Silicon (SoG) mittels Kompensationsdotierung bekannt.

Aus G. Samsonidze et al. "Compensation-doped silicon for photovoltaic applications", Physical review B, Condensed Matter And Material Physics, Bd. 84, Nr. 19, 1.11.2011, XP055386662 ist ein Verfahren zur Behandlung zur Erhöhung der Lichtabsorption mittels Kompensationsdotierung bekannt.

Die US 2013/075855 A1 offenbart ein Verfahren zur Herstellung eines Halbleiter-Leistungselements, wobei auf eine epitaktisch hergestellte Schicht nacheinander unterschiedlich ausgebildete Implantationsmasken mit einer Vielzahl von Implantationsfenstern ausgebildet werden, um in der epitaktisch hergestellten Schicht Bereiche mit einer bestimmten Dotierung durch Implantation auszubilden.

Der vorliegenden Erfindung liegt daher die Aufgabe zugrunde, die Güte des Siliziumwafers zu verbessern. Gelöst ist diese Aufgabe durch ein Verfahren gemäß Anspruch 1, ein Siliziumwafer gemäß Anspruch 7 und der Verwendung einer Vorrichtung zur epitaktischen Herstellung einer Siliziumschicht gemäß Anspruch 15.

Der erfindungsgemäße Siliziumwafer ist bevorzugt mittels des erfindungsgemäßen Verfahrens, insbesondere einer bevorzugten Ausführungsform hiervon, hergestellt. Das erfindungsgemäße Verfahren ist bevorzugt zur Herstellung eines erfindungsgemäßen Siliziumwafers, insbesondere einer bevorzugten Ausführungsform hiervon, ausgebildet.

Die vorliegende Erfindung ist in der Erkenntnis begründet, dass eine elektrisch aktive Nettodotierung des Siliziumwafers eine entscheidende Zielgröße bei der Herstellung solch eines Wafers darstellt, die bisher nicht mit hoher Genauigkeit vorgegeben werden konnte oder kostenintensive Verfahrensschritte erforderte. Insbesondere die Herstellung eines Siliziumwafers mit einer geringen elektrisch aktiven Nettodotierung oder im Grenzfall mit keiner elektrisch aktiven Nettodotierung war nicht mit hoher Präzision möglich oder erforderte kostenintensive Verfahrensschritte.

Die elektrisch aktive Nettodotierung beschreibt hierbei die Konzentration der Dotierstoffe welche zur elektrischen Leitfähigkeit des Halbleitermaterials beitragen, im Gegensatz zur Bruttodotierung, welche die Summe aller in die Halbleiterschicht eingebrachter Dotieratome beschreibt. Hierbei ist die Nettodotierung immer geringer als die Bruttodotierung, aufgrund der Kompensation von gegensätzlich polaren Dotieratomen (n-Dotierstoff und p-Dotierstoff) welche nicht mehr zur elektrischen Leitfähigkeit beitragen.

Untersuchungen und Problemanalysen bei bisherigen Herstellungsverfahren haben ergeben, dass häufig unerwünschte Nebeneffekte zu einer p- oder einer n-Dotierung eines Siliziumwafers bei dessen Herstellung führen. Insbesondere Spuren von Dotierstoffen im zu prozessierenden Ausgangsmaterial oder in der Prozessumgebung führen zu einer schwer zu unterbindenden und zu beeinflussenden Zusammensetzung der Dotierstoffe im Wafer. Hierdurch musste entweder eine geringere Genauigkeit bei der Vorgabe einer elektrisch aktiven Zieldotierung des Siliziumwafers in Kauf genommen werden - insbesondere bei einer gewünschten geringen elektrisch aktiven Nettodotierung oder im Grenzfall bei dem Ziel, einen Siliziumwafer ohne elektrisch aktive Dotierung herzustellen - oder es musste mittels aufwändiger Verfahren vermieden werden, dass im Herstellungsverfahren, insbesondere in einem Prozessraum, in welchem das Silizium zu einem Siliziumwafer verarbeitet wird, dotierende Stoffe enthalten sind.

Gemäß der bisherigen Lehre zur Herstellung eines Siliziumwafers wurde daher stets versucht, ausschließlich elektrisch aktive Dotierstoffe im Umfang der gewünschten elektrisch aktiven Nettodotierung vorzusehen. Dies insbesondere bei den bekannten Ingot-Herstellungsverfahren, da die oben beschriebenen Nachteile insbesondere aufgrund unterschiedlicher Segregationskoeffizienten der einzelnen Dotierstoffe auftreten. Diese Nachteile führen insbesondere zu einer unerwünschten Variation in der Nettodotierkonzentration.

Der erfindungsgemäße Siliziumwafer zur Herstellung eines elektronischen Bauelementes weist hingegen eine p-Dotierung mittels zumindest eines p-Dotierstoffes und eine n-Dotierung mittels zumindest eines n-Dotierstoffes auf. Wesentlich ist, dass die elektrisch aktive Konzentration der p-Dotierung und der n-Dotierung mit einer Konzentration im Bereich 1×10¹⁴ cm⁻³ bis 1×10¹⁶ cm⁻³ ausgebildet ist und dass der Siliziumwafer eine elektrisch aktive Nettodotierung von zumindest 1×10¹⁴ cm⁻³ aufweist.

Bei dem erfindungsgemäßen Siliziumwafer wird somit ein vergleichsweise hoher Anteil zumindest eines p-Dotierstoffes und eines n-Dotierstoffes in einer elektrisch aktiven Konzentration im Bereich 1×10¹⁴ cm⁻³ bis 1×10¹⁶ cm⁻³ ausgebildet. Die Verwendung dieser Dotierstoffe mit entgegengesetztem Dotierungstyp führt zu einer Kompensation der elektrisch aktiven Dotierung, so dass die elektrisch aktive Nettodotierung näherungsweise durch die Differenz der elektrisch aktiven Dichte der beiden entgegengesetzten Dotierungen gegeben ist.

Hierdurch ist somit ein Basisniveau von zumindest 1×10¹⁴ cm⁻³ vorgegeben und eine elektrisch aktive Nettodotierung des Wafers bestimmt sich über die Differenz der n-Dotierkonzentration zu der p-Dotierkonzentration oder umgekehrt. Hierdurch ergeben sich erhebliche Vorteile:
Aufgrund des Basisniveaus von 1×10¹⁴ cm⁻³ haben Verunreinigungen, welche deutlich kleiner als das Basisniveau sind, keinen oder nur einen vernachlässigbaren Einfluss auf die elektrische Leitfähigkeit der Halbleiterschicht. So können erheblich größere Ungenauigkeiten hinsichtlich des Vorhandenseins von dotierenden Stoffen in einem Prozessraum bei der Herstellung des Siliziumwafers toleriert werden, solange deren resultierende elektrisch aktive Dichte bei dem hergestellten Siliziumwafer klein gegenüber dem Basisniveau von 1×10¹⁴ cm⁻³ ist. Hierdurch ergibt sich eine erheblich geringere Anforderung an die Genauigkeit der Gaszusammensetzung in einer solchen Prozesskammer und somit eine Kostenersparnis.

Weiterhin ermöglicht die vorliegende Erfindung die Herstellung von Siliziumwafern mit keiner oder geringer elektrisch aktiver Nettodotierung auf kostengünstige Weise in hoher Präzision: Es ist prozesstechnisch erheblich einfacher, einen Gleichstand der elektrisch aktiven p-Dotierung und der elektrisch aktiven n-Dotierung bei einem Dotierniveau von zumindest 1×10¹⁴ cm⁻³ auszubilden bzw. einen geringen Unterschied zwischen der p- und der n-Dotierung zur Ausbildung einer geringen elektrisch aktiven Nettodotierung zu bewirken. Dies ist zum einen durch die bereits erwähnten Verunreinigungen, welche zu elektrisch aktiven Dotierungen führen, begründet.

Ebenso ist die Zusammensetzung der Dotierstoffe in einer Prozesskammer regelungstechnisch einfacher handhabbar, wenn für das Vorhandensein eines p-Dotierstoffes und für das Vorhandensein eines n-Dotierstoffes Werte vorgegeben sind, die zu einer elektrisch aktiven Dotierung größer 1×10¹⁴ cm⁻³ führen und somit vergleichsweise groß gegenüber bisher vorgegebenen Werten sind. Insgesamt ist somit der Materialfluss, insbesondere der Gasfluss bei Einleiten dotierender Stoffe in eine Prozesskammer bei der vorliegenden Erfindung erheblich einfacher handhabbar, da vergleichsweise größere Konzentrationen von p-Dotierstoff und n-Dotierstoff zur Erzielung des Basisniveaus von zumindest 1×10¹⁴ cm⁻³ gewählt werden.

Die eingangs genannte Aufgabe ist weiterhin durch ein Verfahren zur Herstellung eines Siliziumwafers für ein elektronisches Bauelement gemäß Anspruch 1 gelöst. Das erfindungsgemäße Verfahren weist einen Verfahrensschritt des epitaktischen Aufwachsens einer Siliziumschicht auf ein Trägersubstrat sowie des Ablösens der Siliziumschicht als Siliziumwafer von dem Trägersubstrat auf. Während des epitaktischen Aufwachsens werden zumindest ein p-Dotierstoff und zumindest ein n-Dotierstoff in die Siliziumschicht eingebracht, um eine elektrisch aktive Dotierung auszubilden.

Wesentlich ist, dass das Einbringen der Dotierstoffe in die Siliziumschicht derart erfolgt, dass die Siliziumschicht mit einer elektrisch aktiven p-Dotierung und einer elektrisch aktiven n-Dotierung jeweils mit einer Konzentration im Bereich 1×10¹⁴ cm⁻³ bis 1×10¹⁶ cm⁻³ausgebildet wird und dass der Siliziumwafer mit einer elektrisch aktiven Nettodotierung von zumindest 1×10¹⁴ cm⁻³ ausgebildet wird.

Ein derart hergestellter Siliziumwafer weist somit die zuvor beschriebenen Vorteile auf. Darüber hinaus ist das beschriebene Verfahren des epitaktischen Aufwachsens einer Siliziumschicht auf ein Trägersubstrat und Ablösen der Siliziumschicht als Siliziumwafer von dem Trägersubstrat besonders zu Herstellung solch eines Siliziumwafers geeignet:
Zur Herstellung von Siliziumwafern sind bisher Verfahren verbreitet, bei welchen aus Siliziumblöcken ("Ingots") mittels Sägeverfahren Halbleiterwafer hergestellt werden. Diese Ingots werden aus einer Schmelze des Halbleiters kristallisiert.

Diese Kristallisation ist Diffusionsprozessen unterworfen welche gemäß der Scheil-Gleichung zu einer Ungleichverteilung der Dotierstoffe im Kristall führt.

Die Änderung der Konzentration ist hierbei elementspezifisch und kann in einem kontinuierlichen Kristallisationsprozess nur mit erheblichem Aufwand beeinflusst werden. Ein Anheben des Basis-Dotierniveaus für n-Dotierstoff sowie p-Dotierstoff führt bei einer Kristallisation somit nur mit erheblichem technischem Aufwand zu einer stabilen Nettodotierung, sondern zu einer deutlich verstärkten Inhomogenität des Dotierniveaus über die Länge des Kristalls.

Das Verfahren des epitaktischen Aufwachsen einer Siliziumschicht auf ein Trägersubstrat und anschließendes Ablösen der Siliziumschicht als Siliziumwafer ist an sich bekannt und beispielsweise in R. Brendel, Review of Layer Transfer Processes for Crystalline Thin-Film Silicon Solar Cells. Japanese Journal of Applied Physics, 2001, 40(7R), p. 4431 beschrieben.

Das erfindungsgemäße Verfahren modifiziert somit das bekannte Verfahren zur Herstellung eines Siliziumwafers mittels epitaktischem Aufwachsen, indem während des Aufwachsens sowohl zumindest ein p-Dotierstoff, als auch zumindest ein n-Dotierstoff derart bereitgestellt wird, dass in der Siliziumschicht sich eine elektrisch aktive p-Dotierung von zumindest 1×10¹⁴ cm⁻³ und eine elektrisch aktive n-Dotierung von zumindest 1×10¹⁴ cm⁻³ ausbildet.

Die vorgenannten Vorteile werden verstärkt, wenn in einer bevorzugten Ausführungsform ein höheres Basisniveau der elektrisch aktiven p- und n-Dotierung gewählt wird, insbesondere, dadurch dass der Siliziumwafer eine elektrisch aktive Konzentration der p-Dotierung und der n-Dotierung von jeweils größer 5×10¹⁴ cm⁻³, bevorzugt 1×10¹⁵ cm⁻³, insbesondere 5×10¹⁵ cm⁻³ aufweist. Erfindungsgemäß liegt die elektrisch aktive Konzentration der p-Dotierung und der n-Dotierung im Bereich 1×10¹⁴ cm⁻³ bis 1×10¹⁶ cm⁻³. Ebenso ist es vorteilhaft, das erfindungsgemäße Verfahren zur Ausbildung eines Siliziumwafers mit solchen Parametern auszubilden.

Wie bereits erwähnt, ist es mit einer höheren Genauigkeit oder zumindest erheblich kostengünstiger möglich, eine geringe elektrisch aktive Nettodotierung auf einem Basisniveau einer p- und einer n-Dotierung von zumindest 1×10¹⁴ cm⁻³ zu erzeugen.

Der erfindungsgemäße Siliziumwafer ist daher bevorzugt als ein so genannter hochohmiger Wafer ausgebildet. In dieser vorteilhaften Ausführungsform weist der Siliziumwafer eine elektrisch aktive Nettodotierung auf, so dass der Siliziumwafer einen spezifischen elektrischen Widerstand größer 1 Ωcm, bevorzugt größer 5 Ωcm, insbesondere größer 20 Ωcm aufweist. Solche hochohmigen Wafer sind insbesondere von Interesse zur Verwendung als Hoch-Effizienz Solarzellen, bei welchen unter Beleuchtung die elektrische Leitfähigkeit durch Lichtabsorption erzeugte Ladungsträger bestimmt wird, und nur sekundär durch ins Material eingebrachte Dotieratome.

Alternativ oder zusätzlich ist der Siliziumwafer vorzugsweise mit einer elektrisch aktiven Nettodotierung von zumindest 5×10¹⁴ cm⁻³, insbesondere im Bereich 5×10¹⁴ cm⁻³ bis 1×10¹⁶ cm⁻³, bevorzugt im Bereich 5×10¹⁴cm⁻³ bis 5×10¹⁵cm⁻³ ausgebildet. Die elektrisch aktive Nettodotierung beschreibt die Differenz zwischen der elektrisch aktiven p-Dotierung und der elektrisch aktiven n-Dotierung, wobei jeweils der Dotierungstyp mit der kleineren Dotierung von dem Dotierungstyp mit der höheren Dotierung abgezogen wird, um die elektrisch aktive Nettodotierung (des Dotierungstyps mit der höheren Dotierung) zu bestimmen.

Entsprechend ist in einer vorteilhaften Ausführungsform das Verfahren derart ausgebildet, um einen Siliziumwafer mit den vorgenannten Parametern zu erzeugen.

Bei der Herstellung eines elektronischen Bauelementes ist es wünschenswert, präzise definierte Dotierungen, insbesondere präzise definierte elektrisch aktive Nettodotierungen vorzufinden, da diese wesentliche elektronische Eigenschaften wie beispielsweise Ladungsträgermobilitäten oder Ladungsträgerrekombinationsgeschwindigkeiten beeinflussen können.

Das Basisniveau von elektrisch aktiver p- und n-Dotierung von zumindest 1×10¹⁴ cm⁻³ bei dem erfindungsgemäßen Wafer ermöglicht somit wie vorbeschrieben auch eine präzise Vorgabe des Verlaufs der elektrisch aktiven Nettodotierung insbesondere in Dickenrichtung, d. h. senkrecht zu einer Vorderseite des Siliziumwafers. Es ist daher vorteilhaft, dass der Siliziumwafer eine elektrisch aktive Nettodotierung aufweist, die in Dickenrichtung im Wesentlichen konstant ist. Entsprechend ist das Verfahren vorteilhafterweise derart ausgebildet, dass die Siliziumschicht mit einer in Dickenrichtung im Wesentlichen konstanten elektrisch aktiven Nettodotierung ausgebildet wird.

Alternativ eröffnet die Möglichkeit der präzisen Vorgabe der elektrisch aktiven Nettodotierung jedoch auch die Möglichkeit, gezielt den Verlauf der elektrisch aktiven Nettodotierung in Dickenrichtung vorzugeben. So weist in einer vorteilhaften Ausführungsform der Siliziumwafer eine elektrisch aktive Nettodotierung auf, die in Dickenrichtung einen stufenartigen Verlauf oder einen linearen Verlauf aufweist. Dies ist insbesondere vorteilhaft, um bei photovoltaischen Solarzellen sogenannte "Back Surface Fields" (BSF) oder Driftfelder auszubilden, die die Ladungsträgerrekombination an der Waferoberfläche bzw. im Bulk effektiv reduzieren können. Gleiches gilt für sogenannte "Front Surface Fields" (FSF).

Entsprechend ist das erfindungsgemäße Verfahren bevorzugt derart ausgebildet, dass die Siliziumschicht einen derartigen Verlauf der elektrisch aktiven Nettodotierung aufweist.

Es ist somit insbesondere möglich, einen Verlauf der elektrisch aktiven Nettodotierung in Dickenrichtung zu erzielen, der über einen typischen Verlauf bei Herstellung eines Siliziumwafers aus Ingots abweicht. Dieser typischerweise exponentielle Verlauf, insbesondere Verlauf gemäß des Scheil-Gesetzes ist häufig wünschenswerterweise zu vermeiden. Daher weist der erfindungsgemäße Siliziumwafer vorteilhafterweise eine elektrisch aktive Nettodotierung mit einem in Dickenrichtung nicht exponentiellen Verlauf auf, insbesondere keinen Verlauf gemäß des Scheil-Gesetzes. Die Ausbildung solch eines Siliziumwafers ist insbesondere mittels des erfindungsgemäßen Verfahrens möglich.

Bei dem erfindungsgemäßen Verfahren wird bevorzugt die Siliziumschicht mit einer Dicke von zumindest 50 µm, insbesondere von zumindest 100 µm, insbesondere bevorzugt mit einer Dicke im Bereich 50 µm bis 350 µm aufgebracht. Entsprechend weist der erfindungsgemäße Siliziumwafer vorteilhafterweise eine Dicke von zumindest 50 µm, insbesondere zumindest 100 µm, insbesondere bevorzugt eine Dicke im Bereich 50 µm bis 350 µm auf.

Verfahrenstechnisch besonders einfach und somit kostengünstig ist es, in einer bevorzugten Ausführungsform bei dem erfindungsgemäßen Verfahren zum epitaktischen Aufwachsen der Siliziumschicht in einer Prozesskammer gleichzeitig Gase enthaltend den n-Dotierstoff, den p-Dotierstoff und Silizium enthaltend einzuleiten.

Verfahrenstechnisch ebenso einfach und kostengünstig ist es, in einer bevorzugten Ausführungsform mindestens einen Dotierstoff über feste Dotierquellen, z.B. Phosphorglas oder Borglas oder Phosphor oder Bor enthaltende Keramiken in den Prozess einzubringen.

Der erfindungsgemäße Siliziumwafer ist insbesondere zur Ausbildung von großflächigen Halbleiterbauelementen geeignet, wie beispielsweise großflächigen lichterzeugenden Bauelementen wie LEDs.

Bevorzugt wird der erfindungsgemäße Siliziumwafer zur Herstellung einer photovoltaischen Solarzelle verwendet, da insbesondere bei einer photovoltaischen Solarzelle die Gesamtkosten erheblich von der Qualität und den Kosten der verwendeten Halbleiterschicht abhängen und insbesondere bei einer photovoltaischen Solarzelle eine präzise Vorgabe der elektrisch aktiven Nettodotierung wünschenswert ist. Vorzugsweise ist der Siliziumwafer daher zur Herstellung einer photovoltaischen Solarzelle ausgebildet, insbesondere überdeckt der Siliziumwafer zumindest eine Fläche von zumindest 10×10 cm², so dass eine Vorderseite und eine Rückseite des Siliziumwafers jeweils zumindest eine Fläche von 10×10 cm² aufweist. Alternativ oder zusätzlich ist es vorteilhaft, dass der Siliziumwafer eine Ladungsträgerlebensdauer von zumindest 300 µs, vorzugsweise mindestens 500 µs und/oder dass der Siliziumwafer eine Dicke im Bereich 30 µm bis 300 µm, insbesondere im Bereich 50 µm bis 200 µm aufweist.

Wie vorangehend beschrieben, sind bereits Vorrichtungen bekannt, um auf einem Trägersubstrat eine Siliziumschicht epitaktisch aufzuwachsen. Die eingangs genannte Aufgabe wird daher weiterhin gelöst durch eine Verwendung einer Vorrichtung zur epitaktischen Herstellung einer Siliziumschicht, wobei die Vorrichtung eine Prozesskammer zur Aufnahme eines Trägersubstrats sowie eine Heizvorrichtung zum Heizen der Prozesskammer und zumindest einen Gaseinlass in die Prozesskammer aufweist. Die Vorrichtung ist zur Herstellung eines Siliziumwafers ausgebildet, mit einer p-Dotierung mittels zumindest eines p-Dotierstoffes und eine n-Dotierung mittels zumindest eines n-Dotierstoffes, wobei die elektrisch aktive Dichte der p-Dotierung und der n-Dotierung jeweils mit einer Konzentration im Bereich 1×10¹⁴ cm⁻³ bis 1×10¹⁶ cm⁻³ ausgebildet wird und wobei der Siliziumwafer mit einer elektrisch aktiven Nettodotierung von zumindest 1×10¹⁴ cm⁻³ ausgebildet wird.

Weitere bevorzugte Merkmale und Ausführungsformen werden im Folgenden anhand der Figuren des Ausführungsbeispiels erläutert.

Dabei zeigt:

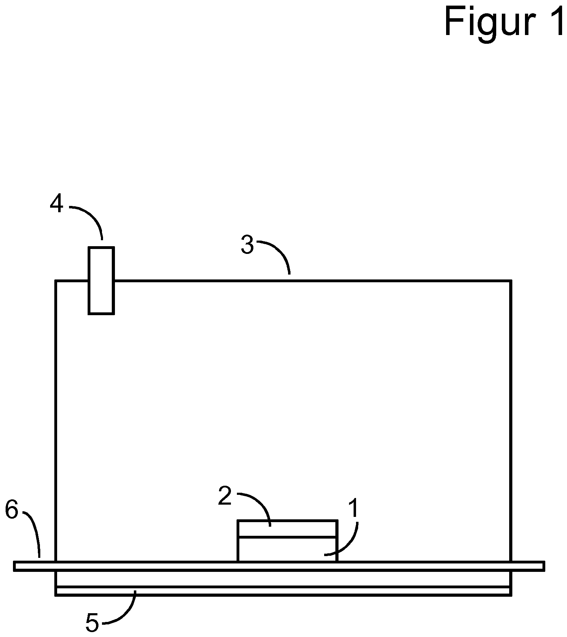

- Figur 1: ein Ausführungsbeispiel einer Vorrichtung zur Durchführung eines Ausführungsbeispiels des erfindungsgemäßen Verfahrens.

Figur 1 zeigt eine Vorrichtung zur epitaktischen Herstellung einer Siliziumschicht. Die Vorrichtung weist eine Prozesskammer 3 zur Aufnahme eines Trägersubstrats 1 auf. Das Trägersubstrat 1 kann mittels einer als Förderband ausgebildeten Fördervorrichtung 6 in die Prozesskammer 3 ein- und ausgefahren werden. Hierzu weist die Prozesskammer 3 Schleusen auf.

Mittels einer Heizvorrichtung 5 ist die Prozesskammer 3 beheizbar. Weiterhin kann über einen Gaseinlass 4 ein Gasstrom in die Prozesskammer 3 eingeführt werden. Über einen Gasauslass kann Gas aus der Prozesskammer abgeführt werden.

Die in Figur 1 dargestellte Vorrichtung und deren Betrieb kann grundsätzlich in an sich bekannter Weise erfolgen, insbesondere wie in WO 2012/084187 oder DE 10 2015 118 042 beschrieben.

In einem Ausführungsbeispiel eines erfindungsgemäßen Verfahrens wird eine (in Figur 1 oben liegende) Oberfläche des Trägersubstrats 1 zunächst porosifiziert. Die Porosifikation eines Trägersubstrates ist an sich bekannt und dient insbesondere dazu, die epitaktisch aufgewachsene Siliziumschicht von dem Trägersubstrat ablösen zu können. Das Trägersubstrat selbst ist ebenfalls aus Silizium ausgebildet.

Das derart vorbehandelte Trägersubstrat wird mittels der Fördervorrichtung 6 in die Prozesskammer 3 eingefahren, bis zu der in Figur 1 dargestellten etwa mittigen Position. Anschließend erfolgt ein epitaktisches Aufwachsen einer Siliziumschicht 2, wobei die Prozesskammer 3 mittels der Heizvorrichtung 5 erwärmt wird und über den Gaseinlass 4 wird Silizium enthaltendes Silan- oder Chlorsilan-Gas sowie beispielsweise Diboran-Gas, welches Bor als p-Dotierstoff und Phosphin-Gas, welches Phosphor als n-Dotierstoff enthält eingeleitet. Alternativ können mehrere Gaseinlässe vorgesehen sein, insbesondere für jedes Gas ein oder mehrere separate Gaseinlässe.

Das epitaktische Aufwachsen der Siliziumschicht 2 erfolgt mit an sich im Wesentlichen bekannten Prozessparametern. Ein wesentlicher Unterschied besteht darin, dass die Gase, welche den p-Dotierstoff und den n-Dotierstoff enthalten in einer derart hohen Konzentration zugeführt werden, dass die Siliziumschicht vorliegend mit einer elektrisch aktiven p-Dotierung von vorliegend 1×10¹⁴ cm⁻³ und mit einer elektrisch aktiven n-Dotierung von vorliegend 6×10¹⁴ cm⁻³ ausgebildet wird.

Die Siliziumschicht weist somit eine elektrisch aktive Nettodotierung des n-Dotiertyps von 5×10¹⁴ cm⁻³ auf und ist somit als hochohmige Siliziumschicht mit etwa 10 Ωcm ausgebildet.

Typische für diesen Prozess verwendbare Prozessparameter sind 1050°C Prozesstemperatur, eine Flussmenge von 50 Standardlitern/Minute Wasserstoff, 1 Standardliter/Minute Chlorsilan, 0,002 Standardliter/Minute in Wasserstoff gelöstes Phosphin und 0,001 Standardliter/Minute in Wasserstoff gelöstes Diboran.

Anschließend wird das Trägersubstrat 1 mit der Siliziumschicht 2 mittels der Fördervorrichtung 6 aus der Prozesskammer 3 herausgefahren und die Siliziumschicht 2 von dem Trägersubstrat 1 gelöst. Die abgelöste Siliziumschicht 2 entspricht somit einem Ausführungsbeispiel eines erfindungsgemäßen Siliziumwafers.

Das Trägersubstrat weist eine in etwa quadratische Oberfläche mit einer Kantenlänge von vorliegend 10 cm auf, so dass auch der resultierende Siliziumwafer in etwa diese Maße aufweist. Der resultierende Siliziumwafer weist vorliegend eine Dicke von 100 µm auf.

In diesem Ausführungsbeispiel wurde die Konzentration sowohl des n-Dotierstoffes, als auch des p-Dotierstoffes während des epitaktischen Aufwachsens konstant gehalten, so dass die Siliziumschicht 2 eine in Dickenrichtung (senkrecht zu der in Figur 1 oben liegenden Vorderseite der Siliziumschicht 2) konstante aktive Nettodotierung aufweist.

Alternativ kann in einem weiteren Ausführungsbeispiel während des epitaktischen Aufwachsens der Gasfluss variiert werden, so dass die Siliziumschicht 2 eine elektrisch aktive Nettodotierung aufweist, die in Dickenrichtung einen stufenartigen Verlauf oder einen linearen Verlauf aufweist. Bevorzugte Verläufe sind hierbei ein stufenartiger oder linearer Verlauf ausgehend von einer elektrisch aktiven Nettodotierung von 1×10¹⁴ cm⁻³ an der dem Trägersubstrat zugewandten Oberfläche der Siliziumschicht 2 zu einer elektrisch aktiven Nettodotierung von 1×10¹⁵ cm⁻³ an der dem Trägersubstrat 1 abgewandten Seite der Siliziumschicht 2 (der Vorderseite der Siliziumschicht 2).

Bei einem stufenartigen Verlauf sind Stufen mit einer relativen Konzentrations-änderung von 10-30%, ausgehend vom tieferen Dotierniveau, vorteilhaft.

Diesen drei vorgenannten Verläufen, der konstanten, stufenartigen oder linearen aktiven Nettodotierung ist gemeinsam, dass kein bei Ingot-Herstellungsverfahren typischer exponentieller Verlauf vorliegt, insbesondere kein Verlauf gemäß des Scheil-Gesetzes.

## Patentansprüche

1. Verfahren zur Herstellung eines Siliziumwafers für ein elektronisches Bauelement,
mit dem Verfahrensschritt epitaktisches Aufwachsen einer Siliziumschicht (2) auf einem Trägersubstrat (1) und Ablösen der Siliziumschicht (2) als Siliziumwafer von dem Trägersubstrat, wobei während des epitaktischen Aufwachsens zumindest ein p-Dotierstoff und zumindest ein n-Dotierstoff in die Siliziumschicht (2) eingebracht wird,
**dadurch gekennzeichnet,**
**dass** das Einbringen der Dotierstoffe in die Siliziumschicht (2) derart erfolgt, dass die Siliziumschicht (2) mit einer elektrisch aktiven p-Dotierung und einer elektrisch aktiven n-Dotierung jeweils mit einer Konzentration im Bereich 1×10¹⁴ cm⁻³ bis 1×10¹⁶ cm⁻³ ausgebildet wird und dass der Siliziumwafer mit einer elektrisch aktiven Nettodotierung von zumindest 1×10¹⁴ cm⁻³ ausgebildet wird.

2. Verfahren nach Anspruch 1,
**dadurch gekennzeichnet,**
**dass** die Siliziumschicht (2) mit einer elektrisch aktiven Nettodotierung ausgebildet wird, so dass der Siliziumwafer einen Schichtwiderstand größer 1 Ωcm, bevorzugt größer 5 Ωcm, insbesondere größer 20 Ωcm aufweist und/oder
der Siliziumwafer mit einer elektrisch aktiven Nettodotierung im Bereich 1×10¹⁴ cm⁻³ bis 1×10¹⁶ cm⁻³, bevorzugt im Bereich 5×10¹⁴ cm⁻³ bis 1×10¹⁵ cm⁻³ ausgebildet wird.

3. Verfahren nach einem der vorangegangenen Ansprüche,
**dadurch gekennzeichnet,**
**dass** die Siliziumschicht (2) mit einer in Dickenrichtung im Wesentlichen konstanten elektrisch aktiven Nettodotierung ausgebildet wird.

4. Verfahren nach einem der vorangegangenen Ansprüche,
**dadurch gekennzeichnet,**
**dass** die Siliziumschicht (2) mit einer elektrisch aktiven Konzentration der p-Dotierung und der n-Dotierung jeweils größer 5×10¹⁴ cm⁻³, bevorzugt 1×10¹⁵ cm⁻³, insbesondere 5×10¹⁵ cm⁻³ ausgebildet wird.

5. Verfahren nach einem der vorangegangenen Ansprüche,
**dadurch gekennzeichnet,**
**dass** die epitaktisch aufgebrachte Siliziumschicht (2) eine Dicke von zumindest 50 µm, insbesondere zumindest 100 µm aufweist.

6. Verfahren nach einem der vorangegangenen Ansprüche,
**dadurch gekennzeichnet,**
**dass** zum epitaktischen Aufwachsen der Siliziumschicht (2) in einer Prozesskammer (3) gleichzeitig Gase enthaltend den n-Dotierstoff, den p-Dotierstoff und Silizium enthaltend eingeleitet werden.

7. Siliziumwafer zur Herstellung eines elektronischen Bauelementes,
mit einer p-Dotierung mittels zumindest eines p-Dotierstoffes und einer n-Dotierung mittels zumindest eines n-Dotierstoffes, ,
**dadurch gekennzeichnet,**
**dass** die elektrisch aktive Konzentration der p-Dotierung und der n-Dotierung jeweils im Bereich 1×10¹⁴ cm⁻³ bis 1×10¹⁶ cm⁻³ liegt und dass der Siliziumwafer eine elektrisch aktive Nettodotierung von zumindest 1×10¹⁴ cm⁻³ aufweist.

8. Siliziumwafer nach Anspruch 7,
**dadurch gekennzeichnet,**
**dass** der Siliziumwafer eine elektrisch aktive Nettodotierung aufweist, so dass der Siliziumwafer einen Schichtwiderstand größer 1 Ωcm, bevorzugt größer 5 Ωcm, insbesondere größer 20 Ωcm aufweist und/oder der Siliziumwafer eine elektrisch aktive Nettodotierung von zumindest 5×10¹⁴ cm⁻³, insbesondere im Bereich 5×10¹⁴ cm⁻³ bis 1×10¹⁶ cm⁻³, bevorzugt im Bereich 5×10¹⁴ cm⁻³ bis 5×10¹⁵ cm⁻³ aufweist.

9. Siliziumwafer nach einem der Ansprüche 7 bis 8,
**dadurch gekennzeichnet,**
**dass** der Siliziumwafer eine elektrisch aktive Nettodotierung aufweist, die in Dickenrichtung im Wesentlichen konstant ist.

10. Siliziumwafer nach einem der Ansprüche 7 bis 8,
**dadurch gekennzeichnet,**
**dass** der Siliziumwafer eine elektrisch aktive Nettodotierung aufweist, die in Dickenrichtung einen stufenartigen Verlauf oder einen linearen Verlauf aufweist.

11. Siliziumwafer nach einem der Ansprüche 7 bis 10,
**dadurch gekennzeichnet,**
**dass** die elektrisch aktive Nettodotierung in Dickenrichtung einen nicht exponentiellen Verlauf aufweist, insbesondere keinen Verlauf gemäß des Scheil-Gesetzes.

12. Siliziumwafer nach einem der vorangegangenen Ansprüche 7 bis 11,
**dadurch gekennzeichnet,**
**dass** die elektrisch aktive Dichte der p-Dotierung und der n-Dotierung jeweils größer 5×10¹⁴ cm⁻³, bevorzugt 1×10¹⁵ cm⁻³, insbesondere 5×10¹⁵ cm⁻³ ist.

13. Siliziumwafer nach einem der vorangegangenen Ansprüche 7 bis 12,
**dadurch gekennzeichnet,**
**dass** der Siliziumwafer zur Herstellung einer photovoltaischen Solarzelle ausgebildet ist, insbesondere, dass der Siliziumwafer zumindest eine Fläche von 10×10 cm² überdeckt und/oder dass der Siliziumwafer eine Ladungsträgerlebensdauer von zumindest 300 µs, bevorzugt 500 µs und/oder dass der Siliziumwafer eine Dicke im Bereich 30 µm bis 300 µm, insbesondere im Bereich 50 µm bis 200 µm aufweist.

14. Verwendung einer Vorrichtung zur epitaktischen Herstellung einer Siliziumschicht (2), mit einer Prozesskammer (3) zur Aufnahme eines Trägersubstrats, einer Heizvorrichtung (5) zum Heizen der Prozesskammer (3) und zumindest einem Gaseinlass (4) in die Prozesskammer (3), zur Herstellung eines Siliziumwafers, mit einer p-Dotierung mittels zumindest eines p-Dotierstoffes und einer n-Dotierung mittels zumindest eines n-Dotierstoffes, wobei die elektrisch aktive Konzentration der p-Dotierung und der n-Dotierung jeweils mit einer Konzentration im Bereich 1×10¹⁴ cm⁻³ bis 1×10¹⁶ cm⁻³ ausgebildet wird und wobei der Siliziumwafer mit einer elektrisch aktiven Nettodotierung von zumindest 1×10¹⁴ cm⁻³ ausgebildet wird.

15. Verwendung eines Siliziumwafers mit einer p-Dotierung mittels zumindest eines p-Dotierstoffes und einer n-Dotierung mittels zumindest eines n-Dotierstoffes zur Herstellung einer photovoltaischen Solarzelle, wobei die elektrisch aktive Dichte der p-Dotierung und der n-Dotierung jeweils mit einer Konzentration im Bereich 1×10¹⁴ cm⁻³ bis 1×10¹⁶ cm⁻³ ausgebildet ist und wobei der Siliziumwafer mit einer elektrisch aktiven Nettodotierung von zumindest 1×10¹⁴ cm⁻³ ausgebildet ist.

## Claims

1. Method for producing a silicon wafer for an electronic component,
having the method step of epitaxially growing a silicon layer (2) on a carrier substrate (1) and detaching the silicon layer (2) as a silicon wafer from the carrier substrate, wherein at least one p-type dopant and at least one n-type dopant are introduced into the silicon layer (2) during the epitaxial growth,
**characterised in that**
the dopants are introduced into the silicon layer (2) such that the silicon layer (2) is formed with an electrically active p-type doping and an electrically active n-type doping, in each case with a concentration in the range of 1×10¹⁴ cm⁻³ to 1×10¹⁶ cm⁻³, and **in that** the silicon wafer is formed with an electrically active net doping of at least 1×10¹⁴ cm⁻³.

2. Method according to claim 1,
**characterised in that**
the silicon layer (2) is formed with an electrically active net doping, such that the silicon wafer has a sheet resistance greater than 1 Ωcm, preferably greater than 5 Ωcm, in particular greater than 20 Ωcm, and/or
the silicon wafer is formed with an electrically active net doping in the range of 1×10¹⁴ cm⁻³ to 1×10¹⁶ cm⁻³, preferably in the range of 5×10¹⁴ cm⁻³ to 1×10¹⁵ cm⁻³.

3. Method according to any one of the preceding claims,
**characterised in that**
the silicon layer (2) is formed with a substantially constant electrically active net doping in the thickness direction.

4. Method according to any one of the preceding claims,
**characterised in that**
the silicon layer (2) is formed with an electrically active concentration of the p-type doping and the n-type doping which is in each case greater than 5×10¹⁴ cm⁻³, preferably 1×10¹⁵ cm⁻³, in particular 5×10¹⁵ cm⁻³.

5. Method according to any one of the preceding claims,
**characterised in that**
the epitaxially applied silicon layer (2) has a thickness of at least 50 µm, in particular at least 100 µm.

6. Method according to any one of the preceding claims,
**characterised in that**
gases containing the n-type dopant, the p-type dopant and silicon are simultaneously introduced into a process chamber (3) in order to epitaxially grow the silicon layer (2).

7. Silicon wafer for producing an electronic component,
having a p-type doping by means of at least one p-type dopant and an n-type doping by means of at least one n-type dopant,
**characterised in that**
the electrically active concentration of the p-type doping and of the n-type doping is in each case in the range of 1×10¹⁴ cm⁻³ to 1×10¹⁶ cm⁻³, and **in that** the silicon wafer has an electrically active net doping of at least 1×10¹⁴ cm⁻³.

8. Silicon wafer according to claim 7,
**characterised in that**
the silicon wafer has an electrically active net doping, such that the silicon wafer has a sheet resistance greater than 1 Ωcm, preferably greater than 5 Ωcm, in particular greater than 20 Ωcm, and/or the silicon wafer has an electrically active net doping of at least 5×10¹⁴ cm⁻³, in particular in the range of 5×10¹⁴ cm⁻³ to 1×10¹⁶ cm⁻³, preferably in the range of 5×10¹⁴ cm⁻³ to 5×10¹⁵ cm⁻³.

9. Silicon wafer according to any one of claims 7 to 8,
**characterised in that**
the silicon wafer has an electrically active net doping which is substantially constant in the thickness direction.

10. Silicon wafer according to any one of claims 7 to 8,
**characterised in that**
the silicon wafer has an electrically active net doping which has a step-like profile or a linear profile in the thickness direction.

11. Silicon wafer according to any one of claims 7 to 10,
**characterised in that**
the electrically active net doping has a non-exponential profile in the thickness direction, in particular no profile according to Scheil's law.

12. Silicon wafer according to any one of the preceding claims 7 to 11,
**characterised in that**
the electrically active density of the p-type doping and of the n-type doping is in each case greater than 5×10¹⁴ cm⁻³, preferably 1×10¹⁵ cm⁻³, in particular 5×10¹⁵ cm⁻³.

13. Silicon wafer according to any one of the preceding claims 7 to 12,
**characterised in that**
the silicon wafer is designed for producing a photovoltaic solar cell, in particular **in that** the silicon wafer covers at least an area of 10×10 cm² and/or **in that** the silicon wafer has a charge carrier lifetime of at least 300 µs, preferably 500 µs and/or **in that** the silicon wafer has a thickness in the range of 30 µm to 300 µm, in particular in the range of 50 µm to 200 µm.

14. Use of a device for epitaxially producing a silicon layer (2), having a process chamber (3) for receiving a carrier substrate, a heating device (5) for heating the process chamber (3) and at least one gas inlet (4) into the process chamber (3), for producing a silicon wafer having a p-type doping by means of at least one p-type dopant and an n-type doping by means of at least one n-type dopant, wherein the electrically active concentration of the p-type doping and of the n-type doping is formed in each case with a concentration in the range of 1×10¹⁴ cm⁻³ to 1×10¹⁶ cm⁻³ and wherein the silicon wafer is formed with an electrically active net doping of at least 1×10¹⁴ cm⁻³.

15. Use of a silicon wafer having a p-type doping by means of at least one p-type dopant and an n-type doping by means of at least one n-type dopant for producing a photovoltaic solar cell, wherein the electrically active density of the p-type doping and of the n-type doping is formed in each case with a concentration in the range of 1×10¹⁴ cm⁻³ to 1×10¹⁶ cm⁻³ and wherein the silicon wafer is formed with an electrically active net doping of at least 1×10¹⁴ cm⁻³.

## Revendications

1. Procédé de fabrication d'une plaquette de silicium pour un composant électronique,
avec l'étape de procédé de croissance épitaxiale d'une couche de silicium (2) sur un substrat porteur (1) et de détachement de la couche de silicium (2) comme plaquette de silicium du substrat porteur, dans lequel pendant la croissance épitaxiale, au moins un dopant p et au moins un dopant n sont introduits dans la couche de silicium (2),
**caractérisé en ce que**,
l'introduction des dopants dans la couche de silicium (2) est effectuée de telle manière que la couche de silicium (2) soit réalisée avec un dopage p actif électriquement et un dopage n actif électriquement respectivement avec une concentration dans la plage de 1×10¹⁴ cm⁻³ à 1×10¹⁶ cm⁻³ et que la plaquette de silicium soit réalisée avec un dopage net actif électriquement d'au moins 1×10¹⁴ cm⁻³.

2. Procédé selon la revendication 1,
**caractérisé en ce que**,
la couche de silicium (2) est réalisée avec un dopage net actif électriquement de sorte que la plaquette de silicium présente une résistance de couche supérieure à 1 Ωcm, de préférence supérieure à 5 Ωcm, en particulier supérieure à 20 Ωcm et/ou
la plaquette de silicium est réalisée avec un dopage net actif électriquement dans la plage de 1×10¹⁴ cm⁻³ à 1×10¹⁶ cm⁻³, de préférence dans la plage de 5×10¹⁴ cm⁻³ à 1×10¹⁵ cm⁻³.

3. Procédé selon l'une quelconque des revendications précédentes,
**caractérisé en ce que**,
la couche de silicium (2) est réalisée avec un dopage net actif électriquement sensiblement constant dans le sens de l'épaisseur.

4. Procédé selon l'une quelconque des revendications précédentes,
**caractérisé en ce que**,
la couche de silicium (2) est réalisée avec une concentration active électriquement du dopage p et du dopage n respectivement supérieurs à 5×10¹⁴ cm⁻³, de préférence 1×10¹⁵ cm⁻³, en particulier 5×10¹⁵ cm⁻³.

5. Procédé selon l'une quelconque des revendications précédentes,
**caractérisé en ce que**,
la couche de silicium (2) appliquée de manière épitaxiale présente une épaisseur d'au moins 50 µm, en particulier d'au moins 100 µm.

6. Procédé selon l'une quelconque des revendications précédentes,
**caractérisé en ce que**,
pour la croissance épitaxiale de la couche de silicium (2), des gaz contenant le dopant n, le dopant p et du silicium sont simultanément introduits dans une chambre de processus (3).

7. Plaquette de silicium pour la fabrication d'un composant électronique,
avec un dopage p au moyen d'au moins un dopant p et un dopage n au moyen d'au moins un dopant n,
**caractérisé en ce que**,
la concentration active électriquement du dopage p et du dopage n se trouve respectivement dans la plage de 1×10¹⁴ cm⁻³ à 1×10¹⁶ cm⁻³ et que la plaquette de silicium présente un dopage net actif électriquement d'au moins 1×10¹⁴ cm⁻³.

8. Plaquette de silicium selon la revendication 7,
**caractérisé en ce que**,
la plaquette de silicium présente un dopage net actif électriquement de sorte que la plaquette de silicium présente une résistance de couche supérieure à 1 Ωcm, de préférence supérieure à 5 Ωcm, en particulier supérieure à 20 Ωcm et/ou la plaquette de silicium présente un dopage net actif électriquement d'au moins 5×10¹⁴ cm⁻³, en particulier dans la plage de 5×10¹⁴ cm⁻³ à 1×10¹⁶ cm⁻³, de préférence dans la plage de 5×10¹⁴ cm⁻³ à 5×10¹⁵ cm⁻³.

9. Plaquette de silicium selon l'une des revendications 7 à 8,
**caractérisé en ce que**,
la plaquette de silicium présente un dopage net actif électriquement qui est sensiblement constant dans le sens de l'épaisseur.

10. Plaquette de silicium selon l'une des revendications 7 à 8,
**caractérisé en ce que**,
la plaquette de silicium présente un dopage net actif électriquement qui présente une étendue étagée ou une étendue linéaire dans le sens de l'épaisseur.

11. Plaquette de silicium selon l'une des revendications 7 à 10,
**caractérisé en ce que**,
le dopage net actif électriquement présente dans le sens de l'épaisseur une étendue non exponentielle, en particulier aucune étendue selon la loi Scheil.

12. Plaquette de silicium selon l'une des revendications précédentes 7 à 11, **caractérisé en ce que**,
l'épaisseur active électriquement du dopage p et du dopage n est respectivement supérieure à 5×10¹⁴ cm⁻³, de préférence 1×10¹⁵ cm⁻³, en particulier 5×10¹⁵ cm⁻³.

13. Plaquette de silicium selon l'une des revendications précédentes 7 à 12,
**caractérisé en ce que**,
la plaquette de silicium est réalisée pour la fabrication d'un panneau solaire photovoltaïque, en particulier que la plaquette de silicium recouvre au moins une surface de 10×10 cm² et/ou que la plaquette de silicium présente une durée de porteur de charge d'au moins 300 µs, de préférence 500 µs et/ou que la plaquette de silicium présente une épaisseur dans la plage de 30 µm à 300 µm, en particulier dans la plage de 50 µm à 200 µm.

14. Utilisation d'un dispositif pour la fabrication épitaxiale d'une couche de silicium (2), avec une chambre de processus (3) pour la réception d'un substrat porteur, d'un dispositif de chauffage (5) pour le chauffage de la chambre de processus (3) et au moins une entrée de gaz (4) dans la chambre de processus (3), pour la fabrication d'une plaquette de silicium, avec un dopage p au moyen d'au moins un dopant p et d'un dopage n au moyen d'au moins un dopant n, dans laquelle la concentration active électriquement du dopage p et du dopage n est réalisée respectivement avec une concentration dans la plage de 1×10¹⁴ cm⁻³ bis 1×10¹⁶ cm⁻³ et dans laquelle la plaquette de silicium est réalisée avec un dopage net actif électriquement d'au moins 1×10¹⁴ cm⁻³.

15. Utilisation d'une plaquette de silicium avec un dopage p au moyen d'au moins un dopant p et un dopage n au moyen d'au moins un dopant n pour la fabrication d'un panneau solaire photovoltaïque, dans laquelle l'épaisseur active électriquement du dopage p et du dopage n est réalisée respectivement avec une concentration dans la plage de 1×10¹⁴ cm⁻³ à 1×10¹⁶ cm⁻³ et dans laquelle la plaquette de silicium est réalisée avec un dopage net actif électriquement d'au moins 1×10¹⁴ cm⁻³.
